# DEMANDE DE BREVET EUROPEEN

(11) **EP 2 672 319 A1**
(43) Date de publication de la demande: **11.12.2013**
(21) Numéro de dépôt: 12170996.8
(22) Date de dépôt: 06.06.2012
(51) Int. Cl.: G03F 7/00, B29C 33/00, C25D 1/16

(54) **Procédé de fabrication de micro-pièces métalliques tridimensionnelles par croissance dans une cavité mixte et micro-pièces obtenues par le procédé.**

(71) Demandeur: Mimotec S.A., 1950 Sion (CH)
(72) Inventeur: Lorenz, Hubert, 1965 Savièse (CH); Genolet, Grégoire, 1926 Fully (CH); Glassey, Marc-André, 1967 Bramois (CH)
(74) Mandataire: Leman Consulting S.A.

(57) **Abrégé**

Le procédé de l'invention permet de fabriquer avec une grande précision des micro-pièces mécaniques métalliques tridimensionnelles comportant deux ou plusieurs parties superposées qui ne peuvent pas être toutes fabriquées par des procédés conventionnels ou utilisant la technologie UV-LIGA. Plusieurs micro-pièces sont produites à la fois sur un même support. Des cavités sont usinées dans une plaque en matière isolante ou conductrice en effectuant des opérations relativement simples comme par exemple, le taraudage, le perçage, le fraisage, l'étampage, l'usinage DRIE, etc., mais difficiles à réaliser par un procédé photolithographique. Ce dernier est utilisé pour des parties des micro-pièces comportant un contour complexe pour la réalisation duquel des opérations d'usinage classiques deviennent difficiles, voire impossibles surtout pour une production par lots. De plus, l'utilisation d'une plaque permet d'atteindre une profondeur des cavités plus élevée que celle réalisable par une couche de photorésist.

## Description

### Domaine de l'invention

La présente invention concerne le domaine de la fabrication de micro-pièces métalliques tridimensionnelles par électroformage en particulier des pièces présentant au moins deux parties ayant chacune une forme prédéfinie. Certaines pièces utilisées notamment dans l'horlogerie comme par exemple des vis, des sautoirs ,des ressorts avec talon, des appliques ou des roues avec pied, des pièces plates avec une base oblique, des pieds-vis, etc., sont également des objets de l'invention ainsi que le procédé permettant de les réaliser avantageusement.

### Arrière plan technique

Le procédé de fabrication de micro-pièces ou composants par irradiation d'une couche photosensible aux rayons ultraviolets suivie d'une étape d'électroformage est connu et est décrit par exemple dans le brevet EP0851295B1.

Ce procédé est dérivé de la technique LIGA (Lithographie Galvanoformung Abformung) qui consiste à:
- déposer sur un substrat une couche de 1 à 2000 µm d'une résine photosensible (photorésist);
- effectuer à travers un masque une irradiation au moyen d'un synchrotron ou par une exposition de rayons ultraviolets;
- développer, c'est-à-dire éliminer par des moyens chimiques les portions de photorésist non polymérisées et créer de ce fait une cavité ou un moule en photorésist.
- électroformer un métal dans cette cavité afin d'obtenir une micro-pièce métallique.

L'avantage de cette technique est de réaliser des pièces ou composants mécaniques d'une très grande précision en X et Y et avec une épaisseur allant jusqu'à plusieurs millimètres. Il est également possible d'appliquer ce procédé en plusieurs étapes pour obtenir un composant en plusieurs niveaux, chaque niveau étant construit sur le précédent.

Ce procédé est décrit plus avant dans la demande de brevet EP1225477A1 et détaille le processus de masquage, d'irradiation et de dissolution de la partie non irradiée. Cette technique est bien connue pour la fabrication de pièces pour l'horlogerie tels que par exemple des roues dentées, des cames, bascules ou ponts.

Plusieurs techniques de fabrication de pièces multi-niveaux basées sur le procédé LIGA sont décrites dans des documents de l'art antérieur à savoir :

EP2157476A1, ce document décrit un procédé de fabrication de pièces métalliques multi niveaux par la technologie UV-LIGA. Chaque couche de photorésist formant les niveaux de la pièce est creusée d'ouvertures formant un moule dans lequel est déposé par électroformage une couche métallique. Les pièces obtenues sont composées de niveaux formés dans un seul métal ou dans plusieurs métaux différents. Les différents niveaux de la cavité ne sont formés que dans des couches de photorésist superposées.

EP1835339A1, ce document décrit un procédé analogue à celui du document EP2157476A1 en utilisant un substrat métallique massif. Des étapes d'usinage intermédiaire de la pièce électroformée dans un moule de photorésist complètent ce procédé. Les différents niveaux du moule sont également formés dans une ou plusieurs couches de photorésist comme dans le document précédent.

EP2405301A1, selon des variantes du procédé, la cavité comporte un plusieurs étages obtenus par gravure profonde d'un substrat en silicium en utilisant le procédé DRIE (Deep Reactive Ion Etching) par exemple et des étages formés par un moule en photorésist. Les étages formés dans le substrat ne comportent que des flancs verticaux et lisses ou un effet de champignonnage ne se présente pas.

Certaines pièces micromécaniques complexes sont très ardues à fabriquer par les moyens traditionnels. Une vis doit par exemple subir de nombreuses opérations d'usinage qui rendent son obtention compliquée en raison des tailles en présence. De plus toutes ces opérations se réalisent de manière sérielle et non pas simultanément en lots ce qui permettrait de gagner en temps et en efficacité. Le procédé décrit ci-dessous permet de pallier ces inconvénients par la fabrication de micro-pièces en combinant des opérations d'usinage mécaniques simples, des opérations photolithographiques, des opérations d'électroformage et des usinages mécaniques finaux. Un avantage de ce procédé est de permettre un usinage de pièces en métal précieux sans produire de déchets, en particulier des pièces en or électroformé .

### Description sommaire de l'invention

Le but de la présente invention est de fabriquer avec une grande précision des micro-pièces mécaniques métalliques tridimensionnelles comportant deux ou plusieurs parties superposées qui ne peuvent pas être toutes fabriquées par des procédés conventionnels ou utilisant la technologie UV-LIGA.

Ce but est atteint par un procédé de fabrication de micro-pièces métalliques comportant au moins deux parties décrit par la revendication 1.

Le procédé permet ainsi de produire plusieurs micro-pièces à la fois c'est-à-dire par lots (batch processing) sur un même support. Les cavités traversantes de la plaque sont usinées en effectuant des opérations relativement simples comme par exemple, le taraudage, le fraisage, l'étampage, le perçage etc., mais difficiles à réaliser par un procédé photolithographique. Dans le cas d'une plaque en silicium, l'usinage des cavités est réalisé par DRIE (Deep Reactive Ion Etching), l'usinage mécanique du silicium étant particulièrement délicat, voire impossible.

Il est à noter que dans le procédé de la présente invention n'est pas limité au type de photorésist utilisé qui peut être soit positif, soit négatif. Dans le cas d'un photoresist positif, par exemple Shipley S1818 ou TOK C-1000, le photomasque est configuré de manière à irradier et dépolymériser des zones de la couche de photorésist déposée destinées à être éliminées, les zones non irradiées c'est-à-dire polymérisées étant conservées.

Dans le cas d'un photorésist négatif, par exemple du type SU-8, le photomasque a une configuration inverse par rapport à celui qui est utilisé pour le photorésist positif, les zones de la couche de photorésist déposée destinées à être conservées sont irradiées et polymérisées et les zones non irradiées c'est-à-dire non polymérisées étant éliminées.

La description du procédé ci-après utilise un photorésist négatif qui permet de réaliser des couches aptes à être photolithographiées plus épaisses que celles réalisées avec un photorésist positif.

Le procédé photolithographique est utilisé pour les parties des micro-pièces comportant un contour complexe pour la réalisation duquel des opérations d'usinage classiques deviennent difficiles, voire impossibles surtout pour une production par lots. De plus, l'utilisation de la plaque permet d'atteindre une profondeur des cavités plus élevée (quelques millimètres) que celle réalisable par une couche de photorésist.

Ce procédé de fabrication exploite le phénomène de champignonnage et de croissance du métal conforme le long des parois des cavités usinées dans la plaque. Pour que ce phénomène puisse se présenter, il est nécessaire d'isoler les parois des cavités usinées dans une plaque métallique.

Selon la géométrie des cavités, les surfaces horizontales peuvent être rendues conductrices si le matériau des cavités est isolant et les parois internes verticales et/ou obliques peuvent être rendues isolantes si le matériau des cavités est conducteur.

La présente invention concerne également une pièce micromécanique monobloc composée d'au moins deux parties métalliques dont une première partie est obtenue par photolithographie grâce à un moule de photorésist et par électroformage, **caractérisée en ce qu'**une seconde partie est obtenue par électroformage d'une couche métallique dans une cavité usinée prolongeant le moule de photorésist et le long d'une paroi de ladite cavité usinée au moins partiellement non verticale.

Les parois internes des cavités usinées de la plaque comportent au moins un flanc structuré de paliers obliques, verticaux ou d'une combinaison de paliers, verticaux, horizontaux ou obliques.

### Brève description des figures

L'invention sera mieux comprise grâce à la description détaillée qui va suivre en se référant aux dessins annexés dans lesquels :
La figure 1 montre les étapes essentielles du procédé selon l'invention en utilisant une plaque usinée en matière isolante sur laquelle est déposée une couche de photorésist. Les cavités mixtes sont formées par un niveau usiné dans la plaque isolante et par un niveau formé dans la couche en photorésist.
La figure 2 montre une variante du procédé avec des cavités mixtes comportant quatre niveaux dont deux sont usinés dans une plaque en matière isolante. La pièce résultante est ainsi formée de trois parties.
La figure 3 illustre un exemple de cavité mixte multi-niveaux dont deux niveaux sont usinés dans deux plaques conductrices superposées et trois niveaux formés dans des couches successives de photorésist.
La figure 4 illustre un autre exemple de cavité mixte multi-niveaux avec des niveaux formés alternativement par des plaques usinées en matière isolante et par des couches de photorésist, le support conducteur étant également usiné. La pièce résultante est ainsi formée de cinq parties.
La figure 5 un exemple de cavité mixte avec dans laquelle une portion de la couche de photorésist est déposée au fond de la cavité usinée de la plaque pour former un trou traversant dans la pièce finale, en l'occurrence un ressort avec talon ou sautoir.

### Description détaillée de l'invention

Les micro-pièces métalliques sont obtenues par électroformage dans une pluralité de cavités mixtes comprenant au moins deux niveaux. Un des niveaux des cavités est réalisé par usinage dans une plaque de matière isolante ou conductrice. L'autre niveau des cavités est formé par photolithographie appliquée sur la plaque.

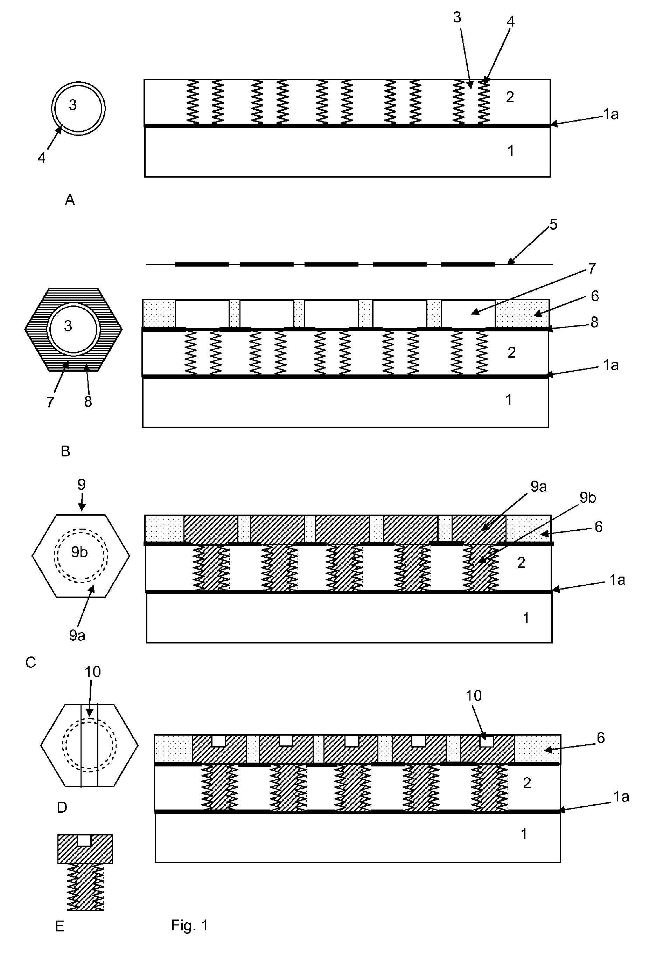

Dans l'exemple de la figure 1 représentant schématiquement la fabrication de vis, le premier niveau des cavités réalise la tige filetée des vis tandis que le second niveau réalise la tête. Les flancs du niveau des cavités formant les tiges filetées sont structurés par une combinaison de paliers obliques disposés verticalement sur toute l'épaisseur de la plaque et obtenus pas taraudage de cette dernière.

Lors de l'étape A, une plaque (2) comportant une pluralité de trous filetés traversants est assemblée sur un support (1) conducteur ou isolant pourvu d'une couche conductrice (1a) déposée par métallisation (chrome, nickel, or ou autres métaux). Le support (1) peut être également constitué de silicium revêtu d'une couche conductrice.

Le premier niveau des cavités (3) est ainsi constitué par les trous filetés fermés par le support (1) conducteur ou rendu conducteur par la couche conductrice (1a) sur lequel est posé la plaque (2) constituant le fond de chaque cavité (3).

Etant donné que l'usinage de la plaque (2) ne peut pas être réalisé par un procédé photolithographique, il est effectué par des moyens conventionnels avec une grande précision par perçage et taraudage d'une pluralité de trous traversants.

L'étape B consiste à déposer sur la plaque (2) une couche de photorésist (6) sensible aux rayons ultraviolets (UV) (ou aux rayons X selon la technologie choisie). La couche de photorésist se compose soit d'une résine liquide étalée en une couche d'épaisseur uniforme sur la plaque (2), soit d'une feuille ou d'une plaque de résine superposée et laminée à chaud sur la plaque (2). Les feuilles ou plaques de résine permettent de former une couche de photorésist sans devoir remplir les cavités précédemment formées et d'éviter une longue étape de séchage.

La couche de photorésist (6) est ensuite irradiée par une source à ultraviolets ou à rayons X à travers une plaque en verre sur laquelle ont été structurés des motifs en chrome ou en or. Cette plaque avec ses découpes de chrome ou d'or est appelée un photomasque (5). La lumière arrivant parfaitement perpendiculairement sur le photomasque (5), seules les portions de photorésist non protégées par les motifs en chrome ou en or seront irradiées. Les flancs des portions de photorésist sont ainsi perpendiculaires à la plaque (2). Dans le cas particulier d'une résine négative comme par exemple le SU8 ou ses dérivés, un recuit de la couche de photorésist (6) provoque la polymérisation dans les zones ayant reçu le rayonnement UV. Cette partie polymérisée devient insoluble dans la plupart des solvants par opposition aux zones non irradiées qui seront dissoutes par un solvant. Le photomasque (5) est positionné de sorte que les motifs soient positionnés au-dessus des cavités (3) usinées de la plaque (2). Dans l'exemple de la figure 1, le photomasque (5) comportant des motifs hexagonaux est disposé de sorte que ces motifs soient centrés au-dessus des trous filetés de la plaque de manière coaxiale à ceux-ci.

Après élimination des portions non polymérisées de la couche de photorésist (6), les cavités (3) usinées sont complétées par une cavité (7) ou moule en photorésist formant un second niveau. Les cavités finales ainsi obtenues forment des cavités mixtes avec un premier niveau usiné et un second niveau obtenu par photolithographie.

Dans le cas d'une plaque (2) en matière isolante comme dans l'exemple de la figure 1, une étape supplémentaire de dépôt d'une couche conductrice (8) sur la surface de la plaque (2) peut être effectuée avant le dépôt de la couche de photorésist (6). Le fond du second niveau des cavités (7) est ainsi constitué par cette couche conductrice (8) servant à faciliter la croissance de la couche métallique (9a, 9b) commencée au fond des cavités usinées de la plaque (2).

Dans le cas d'une plaque (2) métallique, une étape supplémentaire de dépôt d'une couche isolante sur les parois internes des cavités (3) usinées (filetées) est effectuée avant le dépôt de la couche de photorésist (6). Cette isolation assure une croissance régulière de la couche métallique (9a, 9b) depuis le fond des cavités (3) constitué par le support métallique ou métallisé (1) et continuant depuis la face supérieure métallique de la plaque (2).

A l'étape C une couche métallique (9a, 9b) est déposée par électroformage dans la cavité mixte (3, 7). Le métal croît depuis le fond du premier niveau des cavités mixtes constituées par le support (1) pour remplir ce premier niveau et le sillon isolé du filetage par effet de champignonnage ou de débordement. La croissance continue dans le second niveau en photorésist à partir du palier formé par la couche conductrice (8) de la face supérieure de la plaque (2) jusqu'au bord supérieur du moule en photorésist. La couche métallique remplit ainsi entièrement les cavités mixtes pour former un lot de pièces métalliques (vis) sur la plaque (2). La surface de la couche métallique est ensuite usinée par un procédé mécanique pour lui donner une épaisseur prédéfinie (étape D). Des opérations supplémentaires de finition telles que des fraisages, perçages, gravures peuvent également être effectuées sur les micro-pièces dans leur cavité mixte comme dans l'exemple de la figure 1, où des fentes sont fraisées sur la tête des vis.

Le moule en photorésist polymérisé est éliminé par attaque chimique et les micro-pièces (9) sont extraites de la plaque (2), (étape E). Un lot d'une pluralité de micro-pièces (9) est ainsi obtenu dont chaque micro-pièce (9) comporte deux parties superposées (9a, 9b) formées par les niveaux des cavités mixtes (3, 7) correspondant respectivement à la tige filetée et à la tête des vis de l'exemple. Dans le cas où l'extraction de la pièce ne détruit pas la plaque ou le support, ils peuvent être réutilisés.

Selon une variante du procédé, les étapes A et B peuvent être inversées c'est-à-dire que :
- Lors d'une étape B' une couche de photorésist (6a) est déposée sur le support conducteur (1), puis irradiée et polymérisée au moyen d'un photomasque (5), la couche de photorésist (6a) non polymérisée est éliminée et la couche de photorésist restante forme une pluralité de cavités (7a) traversantes.
- Lors d'une étape A', la plaque (2) en matière isolante ou conductrice comprenant une pluralité de cavités (3) traversantes est assemblée sur le support conducteur (1) recouvert par la couche de photorésist (6a) de manière à obtenir une pluralité de cavités mixtes (7a, 3). Celles-ci comportent chacune un premier niveau formé par une cavité (7a) dans la couche de photorésist (6a) et un second niveau formé par une cavité (3) de la plaque (2) positionnée sur le premier niveau.

Les étapes C, D, et E restent inchangées.

Le procédé de l'invention s'applique également pour la production de pièces comportant plus que deux parties superposées utilisant des cavités mixtes comportant plus que deux niveaux. Les niveaux des cavités peuvent être superposés dans un ordre quelconque c'est-à-dire que le ou les niveaux formés par des plaques et le ou les niveaux formés par des moules en photorésist peuvent se succéder de façon quelconque en fonction du profil et de la forme des pièces à fabriquer. Les micro-pièces obtenues comportent ainsi un nombre de parties correspondant au nombre de niveaux des cavités mixtes.

Les parties métalliques de la pièce sont constituées de préférence par un métal tel que de l'or, le nickel (Ni), le cuivre (Cu), le fer (Fe) ou un alliage basé sur un de ces métaux comme par exemple le nickel - phosphore (NiP).

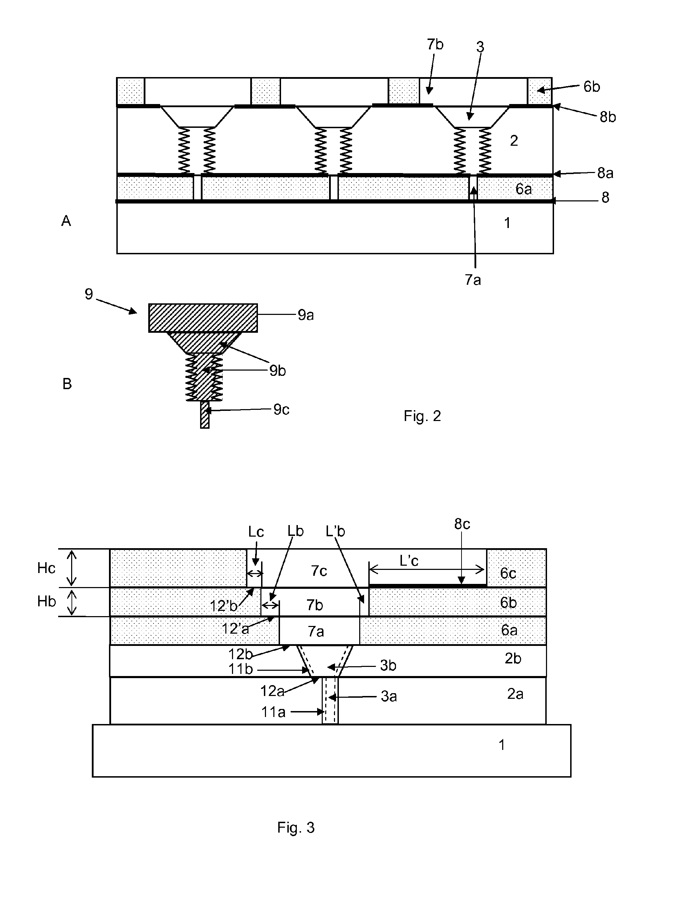

La figure 2A montre un exemple de cavités mixtes multi-niveaux comprenant une première cavité (7a) formée par photolithographie dans une couche de photorésist (6a) appliquée sur la couche conductrice (8) du support (1). Cette première couche de photorésist est recouverte par une couche conductrice (8a) pour former une base à une seconde cavité (3) obtenue par usinage d'une plaque (2) en matière isolante. Après un dépôt d'une seconde couche conductrice (8b) sur la plaque (2), une troisième couche de photorésist (6b) est appliquée dans laquelle une troisième cavité (7b) est formée par photolithographie.

La couche métallique commence sa croissance sur la couche conductrice (8) déposée sur le support (1) dans le premier niveau (7a) puis continue dans le niveau défini par la plaque (2) usinée pour terminer dans la cavité de la couche de photorésist (6b). Le métal remplit les reliefs et la partie de la cavité (3) avec les parois obliques par effet de champignonnage, les parois de la cavité (3) étant isolées. Dans le cas d'une plaque (2) métallique, la couche conductrice (8b) devient superflue et l'isolation des parois de la cavité (3) usinée devient nécessaire. La pièce obtenue (9) comporte ainsi trois parties (9a, 9b, 9c) formées par les trois niveaux de la cavité mixte respectivement (7a), (3) et (7b).

La cavité mixte multi-niveaux de la figure 3 comprend deux cavités (3a, 3b) usinés dans deux plaques (2a, 2b) métalliques superposées et trois cavités (7a, 7b, 7c) formés dans des couches successives de photorésist (6a, 6b, 6c). Les parois des cavités usinées dans les plaques (2a, 2b) sont recouvertes d'une couche d'un matériau isolant (11a, 11 b) assurant une croissance verticale de la couche métallique lors de l'électroformage à partir du support (1) avec débordements le long des parois de ces cavités usinées. Les paliers horizontaux (12a) et (12b) au fond du second et du troisième niveau de la cavité mixte restent conducteurs afin d'assurer la continuité de la croissance de la couche métallique.

Par contre, les paliers horizontaux des cavités en photorésist (7b) et (7c) ne sont pas nécessairement rendus conducteurs par dépôt d'une couche conductrice. En effet, la couche métallique peut déborder par champignonnage sur ces paliers horizontaux lorsque leur largeur n'est pas trop importante par rapport à l'épaisseur de la couche de photorésist. Des essais ont montré que lorsque le rapport entre l'épaisseur de la couche de photorésist et la largeur du palier est plus grand ou égal à 1, la couche métallique croissant depuis le fond conducteur de la cavité peut déborder de manière à recouvrir le palier et croître uniformément le long de la paroi au-dessus du palier jusqu'au niveau du bord de la cavité formée dans la couche de photorésist.

Dans l'exemple de la figure 3, les rapports Hb/Lb et Hb/L'b entre l'épaisseur (Hb) de la couche de photorésist (6b) et la largeur des paliers (Lb) et (L'b) sont supérieurs à 1 ce qui implique que les paliers (Lb) et (L'b) formés par la face supérieure de la couche de photorésist (6a) peuvent être libres de couche conductrice. En ce qui concerne la cavité (7c) formée par la couche de photorésist (6c) déposée sur la couche (6b), la largeur du palier varie entre une petite et une grande valeur (Lc, L'c) par rapport à l'épaisseur (Hc) de la couche de photorésist (6c). Le rapport Hc/Lc entre l'épaisseur de la couche de photorésist (Hc) et la petite valeur de la largeur (Lc) est supérieur à 1 tandis que le rapport entre la même épaisseur (Hc) et la grande valeur de la largeur (L'c) est inférieur à 1. Dans ce cas, le dépôt d'une couche conductrice (8c) devient nécessaire au moins sur les portions du palier de grande largeur (L'c) par rapport à l'épaisseur de la couche de photorésist (Hc). A défaut de couche conductrice (8c) le débordement de la couche métallique peut seulement recouvrir le palier sans que sa croissance continue le long de la paroi de la cavité (7c) jusqu'à son bord supérieur.

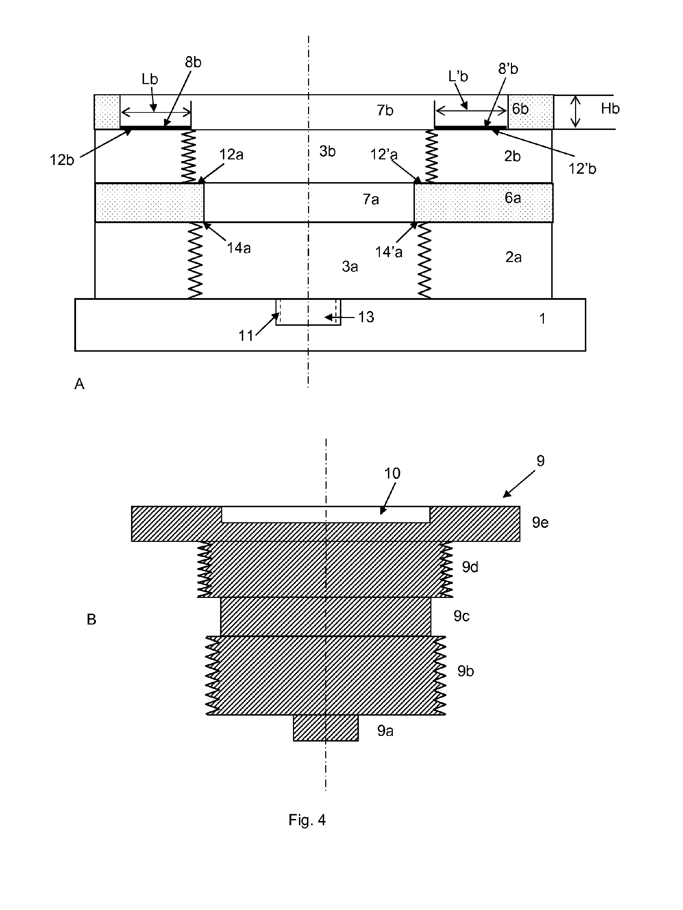

La figure 4A illustre une cavité mixte à cinq niveaux dont le premier niveau est formé par une cavité usinée (13) dans le support conducteur (1). Comme dans les cas d'utilisation de plaques usinées conductrices (cf. figure 3), la paroi de la cavité (13) est recouverte de matière isolante (11). Une première plaque isolante (2a) comportant au moins une cavité usinée (3a) traversante est assemblée sur le support (1) en disposant la cavité usinée (3a) au-dessus de la cavité (13) du support (1) pour former le second niveau. Un troisième niveau est ajouté par une couche de photorésist (6a) déposée sur la première plaque (2a) dans laquelle une cavité (7a) est formée par photolithographie au dessus de la cavité usinée (3a) du second niveau. Une seconde plaque isolante (2b) comportant au moins une cavité usinée (3b) traversante est assemblée sur la couche de photorésist (6a) au-dessus de la cavité (7a) du troisième niveau pour former le quatrième niveau. Finalement un cinquième niveau est formé par une cavité (7b) obtenue par photolithographie au-dessus de la cavité usinée (3b) du quatrième niveau. Une couche conductrice (8b, 8'b) est déposée sur le palier (12b, 12'b) car le rapport entre l'épaisseur (Hb) de la couche de photorésist (6b) et la largeur (Lb, L'b) du palier (12b, 12'b) est inférieur à 1.

D'une manière générale, les niveaux des cavités mixtes multi-niveaux sont disposés en V ou en pyramide inversée de manière à effectuer la croissance de la couche métallique dans des niveaux dont le périmètre du contour augmente globalement avec l'épaisseur de cette couche. Cette configuration s'applique indifféremment de la nature des niveaux, qu'ils soient usinés dans des plaques ou obtenus par photolithographie dans des couches de photorésist.

Selon un cas particulier illustré par la figure 4A, la couche de photorésist (6a) comporte une cavité (7a) dont le contour est entièrement inclus dans le contour de la cavité (3a) usinée dans la plaque isolante (2a) immédiatement inférieure. La différence de périmètre entre les contours des cavités (7a) et (3a) a une valeur déterminée de manière à permettre une croissance uniforme de la couche métallique le long des parois de la première plaque (2a) en passant par les parois de la couche de photorésist (6a) et de la seconde plaque (2b). Le rapport entre la largeur du palier (12a, 12'a) et l'épaisseur de la seconde plaque (2b) est dans ce cas supérieur à 1. De plus, la largeur des décrochements (14a) et (14'a) est déterminée de manière à permettre un remplissage complet de la cavité (3a) par la couche métallique. Par exemple, une largeur de décrochement équivalente à la largeur des décrochements formés sur la paroi de la cavité (3a) par l'usinage de la plaque (2a) satisfait la condition de remplissage complet de cette cavité (3a). En d'autres termes, le rapport entre l'épaisseur de la plaque isolante usinée (2a) immédiatement inférieure et la largeur du décrochement (14a, 14'a) est plus grand ou égal à 1.

La figure 4B montre la pièce micro mécanique monobloc obtenue par la croissance d'une couche métallique dans la cavité mixte de la figure 4A depuis le fond conducteur de la cavité (13) du support (1) jusqu'à la cavité (7b) du cinquième niveau formée dans la couche de photorésist (6b). La pièce comporte ainsi cinq parties (9a, 9b, 9c, 9d, 9e) issues des cinq niveaux de la cavité mixte. Un usinage final (10) peut être effectué dans la partie (9e) de la pièce après électroformage de celle-ci dans la cavité mixte.

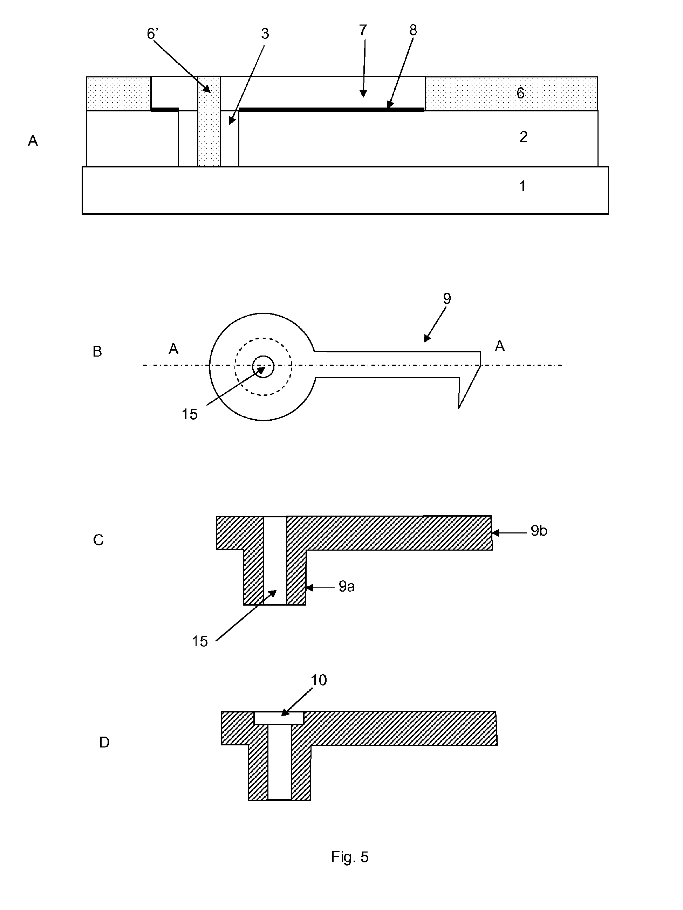

La figure 5A montre un exemple de cavité mixte à deux niveaux dont le premier niveau est formé par une cavité (3) usinée dans une plaque (2) en silicium par le procédé DRIE. Cette plaque (2) est posée sur un support (1) conducteur, en général métallique, qui, selon une variante, peut être également constitué de silicium recouvert d'une couche conductrice sur sa surface supérieure correspondant au fond de la cavité (3).

Le second niveau constitué par une cavité (7) est formé par photolithographie dans une couche de photorésist (6) appliquée sur la plaque de silicium (2). Dans cet exemple, la couche de photorésist (6) est déposée sur la plaque (2), irradiée et polymérisée au moyen d'un photomasque en masquant partiellement la cavité (3), afin de déposer une portion (6') de cette couche sur le fond de la cavité usinée (3).

Le fond de la cavité (7) du second niveau est recouvert d'une couche conductrice (8) car la face supérieure de la plaque (2) en silicium est considérée comme isolante du point de vue de l'électroformage. La couche métallique croît depuis le fond conducteur de la cavité usinée (3), le long des parois isolantes de la plaque (2) de silicium et de la portion de la couche de photorésist (6') pour aboutir dans la seconde cavité (7) dans laquelle la couche métallique poursuit sa croissance à partir de la couche conductrice (8) pour remplir entièrement la cavité (7).

La micro pièce terminée, un ressort avec talon ou sautoir (9) représenté schématiquement par la figure 5B, comporte un trou traversant (15) réalisé grâce à la portion de la couche de photorésist (6') déposée au fond de la cavité usinée (3). La partie inférieure (9a), talon du ressort, est ainsi formée dans la cavité usinée (3) tandis que la partie supérieure (9b), ressort, ayant un contour plus complexe est formée dans la cavité (7) de la couche de photorésist (6), voir la figure 5B et la coupe A-A de la figure 5C.

Un usinage final, tel qu'un fraisage (10) illustré par la coupe de la figure 5D, peut être également réalisé sur la micro pièce après sa croissance dans la cavité mixte et avant l'extraction des pièces.

Il est à noter que dans la réalisation des exemples des figures 1, 2, 3 et 4, les photomasques utilisés pour former les cavités dans les couches de photorésist couvrent complètement les cavités du niveau immédiatement inférieur.

Les pièces micro mécaniques ainsi obtenues à partir de cavités mixtes multi-niveaux comprennent une succession, dans un ordre prédéterminé, de parties métalliques superposées obtenues par électroformage dans un moule de photorésist et par électroformage dans une cavité usinée prolongeant le moule de photorésist. La couche métallique croît dans la cavité usinée le long d'une paroi comportant au moins un palier oblique ou horizontal ou une structure formée d'une combinaison de paliers horizontaux, verticaux ou obliques.

Une pièce micro mécanique monobloc obtenue par le procédé de l'invention ne peut pas se distinguer à priori d'une pièce fabriquée par des procédés conventionnels d'usinage tels que le décolletage ou l'étampage. Par contre, la pièce peut être différenciée par observation au microscope de la structure cristalline du métal qui présente des caractéristiques propres au métal électroformé dans les niveaux successifs d'une cavité mixte, caractéristiques qui sont absentes de la structure d'un métal usiné.

Les micro-pièces comprennent en général au moins une partie usinée lors d'une étape postérieure à la croissance de la couche métallique monobloc.

## Revendications

1. Procédé de fabrication de micro-pièces métalliques comportant au moins deux parties dont au moins une partie étant obtenue par photolithographie et électroformage, cette méthode comprenant au moins les étapes suivantes:
A) assembler sur un support conducteur (1) au moins une plaque (2) en matière isolante ou conductrice comprenant une pluralité de cavités (3) traversantes,
B) déposer une couche de photorésist (6) sur la plaque (2), irradier et polymériser au moyen d'un photomasque (5) en masquant partiellement ou complètement chaque cavité (3) et au moins une zone de la couche de photorésist localisée dans le voisinage de chaque cavité (3), éliminer la couche de photorésist (6) non polymérisée de manière à obtenir une pluralité de cavités mixtes (3, 7) comportant un premier niveau formé par la cavité (3) de la plaque (2) et un second niveau formé dans la couche de photorésist (6) positionnée sur le premier niveau,
ou
B') déposer sur un support conducteur (1) une couche de photorésist (6a), irradier et polymériser la couche de photorésist (6a) au moyen d'un photomasque (5) et éliminer la couche de photorésist (6a) non polymérisée, la couche de photorésist restante formant une pluralité de cavités (7a) traversantes,
A') assembler au moins une plaque (2) en matière isolante ou conductrice comprenant une pluralité de cavités (3) traversantes sur le support conducteur (1) recouvert par la couche de photorésist (6a) de manière à obtenir une pluralité de cavités mixtes (7a, 3) comportant chacune un premier niveau formé par une cavité (7a) dans la couche de photorésist (6a) et un second niveau formé par une cavité (3) de la plaque (2) positionnée sur le premier niveau,
C) déposer une couche métallique (9a, 9b) par électroformage dans chaque cavité mixte (3, 7) de manière à remplir le premier et le second niveau,
D) usiner par un procédé mécanique la couche métallique (9a, 9b) à une épaisseur prédéfinie, éliminer le photorésist polymérisé,
E) extraire la couche métallique (9a, 9b) de chaque cavité (3) de la plaque (2) et du support conducteur (1) et obtenir une pluralité de micro-pièces (9) comportant deux parties superposées formées par les niveaux des cavités mixtes (3, 7).

2. Procédé selon la revendication 1 **caractérisé en ce que** les cavités de la plaque (2) comportent des parois internes comprenant au moins un flanc structuré de paliers obliques, verticaux ou d'une combinaison de paliers, verticaux, horizontaux ou obliques.

3. Procédé selon la revendication 1 ou 2 dans lequel la plaque (2) assemblée sur le support conducteur (1) lors de l'étape A est en matière isolante **caractérisé en ce que** les cavités (7) formées dans la couche de photorésist (6) ont une géométrie nécessitant un dépôt d'une couche conductrice (8) sur la surface de la plaque (2) effectué avant le dépôt de la couche de photorésist (6) lors de l'étape B.

4. Procédé selon la revendication 1 ou 2 dans lequel la plaque (2) assemblée sur le support conducteur (1) lors de l'étape A ou sur la couche de photorésist (6a) recouvrant ledit support conducteur (1) lors de l'étape A' est en matière conductrice **caractérisé en ce que** les cavités (3) traversantes ont une géométrie nécessitant un dépôt de matière isolante sur les parois internes desdites cavités (3).

5. Procédé selon la revendication 1 ou 2 dans lequel la plaque (2) assemblée sur la couche de photorésist (6a) recouvrant le support conducteur (1) lors de l'étape A' est en matière isolante **caractérisé en ce que** les cavités (3) de la plaque (2) ont une géométrie nécessitant un dépôt d'une couche conductrice (8) sur la couche de photorésist (6a) après l'obtention des cavités (7a) dans ladite couche de photorésist (6a) lors de l'étape B'.

6. Procédé selon l'une des revendications 1 à 5 **caractérisé en ce qu'**il comprend au moins une opération supplémentaire d'usinage de la couche métallique effectuée avant l'élimination du photorésist polymérisé et du support conducteur (1).

7. Procédé selon l'une des revendications 1 à 6 **caractérisé en ce qu'**il comprend une succession d'étapes supplémentaires dans un ordre prédéterminé de formation d'une pluralité de niveaux de cavités mixtes multi-niveaux par assemblage de plaques (2) en matière isolante ou conductrice comprenant une pluralité de cavités (3) traversantes réalisées par usinage et d'obtention de niveaux par photolithographie dans des couches de photorésist, lesdits niveaux étant disposés de sorte que la couche métallique croisse dans des niveaux ayant un périmètre de contour qui augmente globalement avec l'épaisseur de ladite couche métallique, les micro-pièces obtenues comportant un nombre de parties correspondant au nombre de niveaux des cavités mixtes.

8. Procédé selon l'une des revendications 1 à 7 **caractérisé en ce qu'**il comprend une étape préalable d'usinage de cavités (13) dans le support conducteur (1) et une étape de dépôt d'une couche isolante (11) sur les parois internes des cavités (13).lorsque lesdites cavités (13) ont une géométrie nécessitant ledit dépôt.

9. Pièce micro mécanique monobloc composée d'au moins deux parties métalliques dont une première partie est obtenue par photolithographie grâce à un moule de photorésist et par électroformage, **caractérisée en ce qu'**une seconde partie est obtenue par électroformage d'une couche métallique dans une cavité usinée prolongeant le moule de photorésist et le long d'une paroi de ladite cavité usinée au moins partiellement non verticale.

10. Pièce selon la revendication 9 **caractérisée en ce qu'**elle comprend une succession, dans un ordre prédéterminé, de parties métalliques superposées obtenues par photolithographie grâce à un moule de photorésist et par électroformage et de parties obtenues par électroformage d'une couche métallique dans une cavité usinée comportant des parois au moins partiellement non verticales.

11. Pièce selon la revendication 9 ou 10 **caractérisée en ce qu'**elle comporte des parois externes comprenant des flancs obliques, verticaux ou d'une combinaison de flancs, verticaux, horizontaux ou obliques.

12. Pièce selon l'une des revendications 9 à 11 **caractérisée en ce qu'**elle comprend au moins une partie usinée lors d'une étape postérieure à la croissance des couches métalliques dans le ou les moule(s) de photorésist et dans la ou les cavité(s) usinée(s).

13. Pièce selon l'une des revendications 9 à 12 **caractérisée en ce que** les parties métalliques comportent un métal sélectionné dans un groupe comprenant de l'or, du nickel, du cuivre, du fer ou un alliage basé sur un de ces métaux.

14. Pièce selon l'une des revendications 9 à 13 **caractérisée en ce qu'**elle est sélectionnée dans un groupe de composants comprenant des vis, des sautoirs ,des ressorts avec talon, des appliques ou des roues avec pied, des pièces plates avec une base oblique, des pieds-vis, etc.
